# EUROPEAN PATENT APPLICATION

(11) **EP 4 273 903 A1**
(43) Date of publication of application: **08.11.2023**
(21) Application number: 23171363.7
(22) Date of filing: 03.05.2023
(51) Int. Cl.: H01J 37/32, C23C 16/455

(54) **METHOD OF FABRICATING AN ELECTRODE STRUCTURE AND APPARATUS THEREFOR**

(30) Priority: 03.05.2022 KR 20220055056; 05.10.2022 KR 20220127180
(71) Applicant: Samsung Electronics Co., Ltd., Suwon-si, Gyeonggi-do 16677 (KR)
(72) Inventor: KIM, Dohyung, 16677 Suwon-si (KR)
(74) Representative: Marks & Clerk LLP

(57) **Abstract**

An apparatus and method for fabricating an electrode structure. The method may include forming a first gate electrode, performing a removal process on an electrode capping layer formed on the first gate electrode, forming a second gate electrode on the first gate electrode, and nitridating an upper portion of the second gate electrode.

## Description

### BACKGROUND OF THE INVENTION

The present disclosure relate to method of fabricating electrode structures and apparatuses for fabricating the electrode structures, and in particular, to methods of fabricating electrode structures of semiconductor devices and apparatuses for fabricating the electrode structures.

Due to their small-sized, multifunctional, and/or low-cost characteristics, semiconductor devices are being esteemed as important elements in the electronics industry. Types of semiconductor devices include a semiconductor memory device for storing data, a semiconductor logic device for processing data, and a hybrid semiconductor device including both of memory and logic elements.

Due to the increased demand for electronic devices with a fast speed and/or a low power consumption, a fast operating speed and/or a low operating voltage are required for the semiconductor device embedded in the electronic devices, and to reduce sizes of the electronic devices, it is necessary to increase an integration density of the semiconductor device. Accordingly, various studies are conducted to reduce a pattern size of the semiconductor device and to improve electrical and reliability characteristics of the semiconductor device. For example, many studies on a structure of an electrode in the semiconductor device are being actively conducted.

### SUMMARY

Some example embodiments of the inventive concepts provides methods of fabricating electrode structures with improved electrical characteristics and apparatuses for fabricating the electrode structure.

Some example embodiments of the inventive concepts provide methods capable of increasing productivity in a process of fabricating electrode structures and apparatuses for fabricating the electrode structure.

According to some example embodiments of the inventive concepts, a method of fabricating an electrode structure may include (a) forming a first gate electrode, (b) performing a removal process on an electrode capping layer formed on the first gate electrode, (c) forming a second gate electrode on the first gate electrode, and (d) nitridating an upper portion of the second gate electrode.

According to some example embodiments of the inventive concepts, a method of fabricating an electrode structure may include (a) forming a first gate electrode, (b) performing a removal process on an electrode capping layer formed on the first gate electrode, and (c) forming a second gate electrode on the first gate electrode. The step (c) may include growing the second gate electrode using a top surface of the first gate electrode as a seed.

According to some example embodiments of the inventive concepts, an apparatus for fabricating the electrode structure may include a plate, a shower head configured to provide plasma to the plate, a plasma box configured to provide the plasma to the shower head, a precursor box configured to provide a precursor to the shower head, a purge box configured to provide a purge gas to the shower head, and a reactant box configured to provide a reactant to the shower head.

According to some example embodiments of the inventive concepts, an apparatus for fabricating the electrode structure may include a plate, a shower head configured to supply an etchant and an interface forming gas toward the plate, a first box configured to provide the etchant to the shower head, a second box configured to provide the interface forming gas to the shower head, a precursor box configured to provide a precursor to the shower head, a purge box configured to provide a purge gas to the shower head, and a reactant box configured to provide a reactant to the shower head. The plate may include a heater, and the interface forming gas may contain a nitrogen atom.

At least some of the above and other features of the invention are set out in the claims.

### BRIEF DESCRIPTION OF THE DRAWINGS

FIG. 1 is a flow chart illustrating a method of fabricating an electrode structure, according to some example embodiments of the inventive concepts.
FIGS. 2 to 4 are sectional views illustrating a method of fabricating an electrode structure, according to some example embodiments of the inventive concepts.
FIGS. 5A and 5B are conceptual diagrams illustrating a fabrication apparatus, which is used to fabricate an electrode structure according to some example embodiments of the inventive concepts.
FIGS. 6, 11, 16, 21, 26, and 31 are plan views illustrating a method of fabricating a semiconductor device including an electrode structure, according to some example embodiments of the inventive concepts.
FIGS. 7, 12, 17, 22, 27, and 32 are sectional views taken along lines A-A' of FIGS. 6, 11, 16, 21, 26, and 31, respectively.
FIGS. 8, 13, 18, 23, 28, and 33 are sectional views taken along lines B-B' of FIGS. 6, 11, 16, 21, 26, and 31, respectively.
FIGS. 9, 14, 19, 24, 29, and 34 are sectional views taken along lines C-C' of FIGS. 6, 11, 16, 21, 26, and 31, respectively.
FIGS. 10, 15, 20, 25, 30, and 35 are sectional views taken along lines D-D' of FIGS. 6, 11, 16, 21, 26, and 31, respectively.

### DETAILED DESCRIPTION

Example embodiments of the inventive concepts will now be described more fully with reference to the accompanying drawings, in which example embodiments are shown.

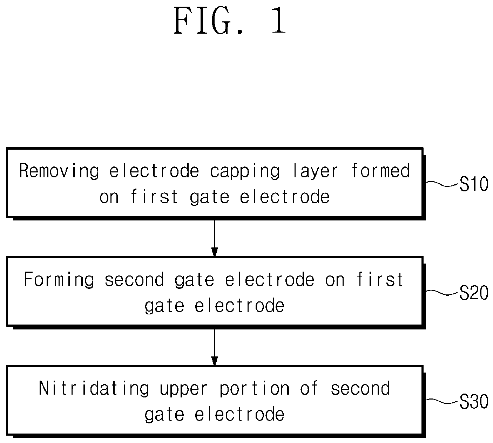

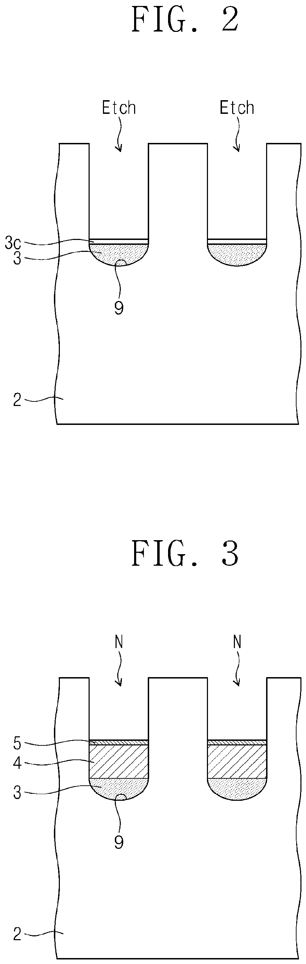

FIG. 1 is a flow chart illustrating a method of fabricating an electrode structure, according to some example embodiments of the inventive concepts. FIGS. 2 to 4 are sectional views illustrating a method of fabricating an electrode structure, according to some example embodiments of the inventive concepts.

Referring to FIGS. 1 and 2, a base substrate 2 may be prepared. The base substrate 2 may be a semiconductor substrate, such as a silicon wafer, a germanium wafer, or a silicon-germanium wafer. In the present specification, each of the expressions of "A or B", "at least one of A and B", "at least one of A or B", "A, B, or C", "at least one of A, B and C ", and "at least one of A, B, or C" will be used to represent one of possible combinations of elements listed in the expression.

A trench region 9 may be formed to cross the base substrate 2. The formation of the trench region 9 may include forming a mask pattern (not shown) on the base substrate 2 and etching an upper portion of the base substrate 2 using the mask pattern as an etch mask. In some example embodiments, the base substrate 2 may be formed to have a plurality of trench regions 9. The trench regions 9 may be spaced apart from each other. As an example, the trench regions 9 may be formed to have the same depth or different depths. In other words, bottom surfaces of the trench regions 9 may be formed at the same level or at different levels. Hereinafter, the term "level" may be defined as a height measured from a bottom surface of the base substrate 2.

A first gate electrode 3 may be formed in the trench region 9. The formation of the first gate electrode 3 may include forming a first gate layer (not shown) to fill the trench regions 9 and cover the base substrate 2 and etching an upper portion of the first gate layer to form a plurality of first gate electrodes 3 separated from each other. The formation of the first gate layer may include performing a physical vapor deposition (PVD) process, a chemical vapor deposition (CVD) process, or an atomic layer deposition (ALD) process. The etching of the upper portion of the first gate layer may include performing an etch-back process on the first gate layer. Accordingly, the first gate electrode 3 may fill a lower portion of the trench region 9. Top surfaces of the first gate electrodes 3 may be located at substantially the same level, but the inventive concepts are not limited to this example.

The first gate electrode 3 may be formed of or include at least one metallic material (e.g., Ti, Mo, W, Cu, Al, Ta, Ru, and Ir), a nitride material of the metallic element, or combinations thereof. As an example, the first gate electrode 3 may be formed of or include TiN.

In some example embodiments, before the formation of the first gate electrode 3, a gate insulating layer (not shown) may be further formed to conformally cover an inner surface of the trench region 9 and a top surface of the base substrate 2. A gate insulating layer GIL may be formed of or include at least one of silicon oxide, a high-k dielectric material, or combinations thereof. The high-k dielectric material may be defined as a material having a dielectric constant higher than that of silicon oxide. For example, the high-k dielectric material may include one or more metal oxides (e.g., aluminum oxide).

In some example embodiments, an electrode capping layer 3c may be formed on the first gate electrode 3. An electrode capping layer 3c may be formed as a result of oxidation of an upper portion of the first gate electrode 3. Even when an additional oxidation process is not performed, the first gate electrode 3 may be naturally oxidized to form the electrode capping layer 3c. Thus, the electrode capping layer 3c may include the same element as at least one of elements in the material constituting the first gate electrode 3, and in some example embodiments, the electrode capping layer 3c may be formed of or include an oxide material containing the same element as that in the first gate electrode 3. As an example, in the case where the first gate electrode 3 includes TiN, the electrode capping layer 3c may be formed of or include TiO. The electrode capping layer 3c may fully or partially cover a top surface of the first gate electrode 3.

Next, a removal process may be performed on the upper portion of the first gate electrode 3 (in S10). As an example, the removal process may be performed on the electrode capping layer 3c, which is formed on the first gate electrode 3. The top surface of the first gate electrode 3 may be exposed to the outside, because the electrode capping layer 3c is removed by the removal process. The removal process may include an etching process (e.g., a dry etching process or a wet etching process). In the etching process, an etchant may be supplied to the electrode capping layer 3c. In some example embodiments, the etchant may include a chlorine (Cl) atom, but the inventive concepts are not limited to this example. For instance, the etchant may comprise a compound or molecule containing chlorine (e.g. containing at least one chlorine atom) or may comprise one or more chlorine ions. The etching process may be performed at the temperature range from 300°C to 700°C under the pressure range from 3 Torr to 15 Torr (0.4 kPa to 2 kPa).

Referring to FIGS. 1 and 3, a second gate electrode 4 may be formed on the first gate electrode 3 (in S20). The formation of the second gate electrode 4 may include growing the second gate electrode 4 using the top surface of the first gate electrode 3 as a seed. That is the top surface of the first gate electrode 3 may act as a seed (or seed layer) for growth of the second gate electrode 4. Thus, the second gate electrode 4 may be selectively grown on the top surface of the first gate electrode 3, but not on the top surface of the base substrate 2.

Concretely, in the selective growth of the second gate electrode 4, a precursor (not shown) may be provided and deposited on the top surface of the first gate electrode 3. After the deposition of the precursor, a purge process may be performed to exhaust a portion of the precursor, which is not deposited on the top surface of the first gate electrode 3. The purge process may be performed using an inert gas (e.g., containing an element of group-18 of the periodic table). After the exhaust of the precursor, a reactant (not shown) may be provided on the precursor on the first gate electrode 3. As a result of a chemical reaction between the precursor and the reactant, a created material and a residual material may be produced. Next, an additional purge process may be performed. As a result, the residual material may be exhausted, and the created material may be left on the top surface of the first gate electrode 3. An additional precursor may be again deposited on the created material using the created material as a seed. Thereafter, the purge and reaction processes may be repeatedly performed. As a result of the repetition of the processes, the created materials may be cumulatively left on the first gate electrode 3. The created materials, which are accumulated on the first gate electrode 3, may constitute the second gate electrode 4.

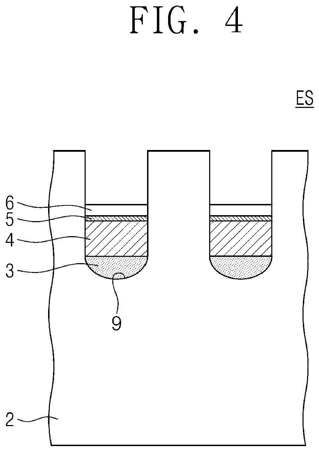

In the case where the top surface of the first gate electrode 3 is covered with the electrode capping layer 3c, the precursor may not be deposited on the top surface of the first gate electrode 3. This may lead to a difficulty in forming the second gate electrode 4 on the top surface of the first gate electrode 3. According to some example embodiments of the inventive concepts, since the electrode capping layer 3c is removed before the formation of the second gate electrode 4, the top surface of the first gate electrode 3 may be exposed to the outside. Accordingly, it may be possible to easily form the second gate electrode 4 and consequently to reduce a failure in a process of fabricating an electrode structure ES of FIG. 4.

The second gate electrode 4 may be formed on the first gate electrode 3 to fill the trench region 9 and may be formed at a level lower than the top surface of the base substrate 2. Top surfaces of the second gate electrodes 4, which are formed to fill the trench regions 9, respectively, may be formed at substantially the same height as each other, but the inventive concepts are not limited to this example.

The second gate electrode 4 may be formed of or include at least one metallic material (e.g., Ti, Mo, W, Cu, Al, Ta, Ru, and Ir), a nitride material of the metallic element, or combinations thereof. The second gate electrode 4 may be formed of or include a material different from the first gate electrode 3. In the case where the first gate electrode 3 includes TiN, the second gate electrode 4 may be formed of or include Mo.

The precursor of the second gate electrode 4 may further include another material, in addition to a material of the second gate electrode 4. For example, in the case where the second gate electrode 4 includes an arbitrary metallic element (hereinafter, M), the precursor may be formed of or include a material that has a chemical formula of MX, where X is a compound (e.g., Cl₅ or Cl₂O₂) that can participate in a chemical reaction with the metallic element M (e.g. a compound including chlorine). As an example, the precursor may include MoCls, and the created material, which is produced from the precursor and is used as the second gate electrode 4, may include Mo. The reactant may include a material, which can react with the precursor MX and can be used to separate the elements of M and X from each other. As an example, in the case where the precursor includes MoCls, the reactant may include H₂.

After the formation of the second gate electrode 4, an upper portion of the second gate electrode 4 may be nitridated (in S30). As a result, an interface pattern 5 may be formed on the second gate electrode 4. The interface pattern 5 may cover a top surface of the second gate electrode 4. Since the interface pattern 5 is formed by the nitridation process, a material of the interface pattern 5 may include not only the same element as the second gate electrode 4 but also nitrogen (N) atoms. For example, in the case where the second gate electrode 4 includes molybdenum (Mo), the interface pattern 5 may include molybdenum nitride (MoN). However, the materials of the second gate electrode 4 and the interface pattern 5 are not limited to the above examples. Herein the terms nitridating and nitridated are used. The skilled person will understand that these terms are synonymous with nitriding and nitrided, respectively.

The nitridation process may be performed by various methods.

As an example, the nitridation process may include a thermal nitridation process to be performed on the second gate electrode 4. The thermal nitridation process may include heating the second gate electrode 4 and providing an interface forming gas to an upper portion of the second gate electrode 4. In some example embodiments, the second gate electrode 4 may be heated to a temperature of 650°C or higher. The interface forming gas, which is provided to the second gate electrode 4, may include nitrogen (N) atoms. The upper portion of the second gate electrode 4 may chemically react with the interface forming gas, under high-temperature environment, and thus, the upper portion of the second gate electrode 4 may be nitridated to form the interface pattern 5. The thermal nitridation process may be performed under the pressure range from 3 Torr 40 Torr (0.4 kPa to 5.3 kPa).

As another example, the nitridation process may include a plasma nitridation process. The plasma nitridation process may include providing nitrogen plasma to the upper portion of the second gate electrode 4, under the environment of high temperature and high pressure. The upper portion of the second gate electrode 4 may react with the nitrogen plasma, and as a result, the upper portion of the second gate electrode 4 may be nitridated to form the interface pattern 5. The plasma nitridation process may be performed under the pressure range from 3 Torr to 40 Torr (0.4 kPa to 5.3 kPa) and 250°C and under the temperature condition of 700°C or lower.

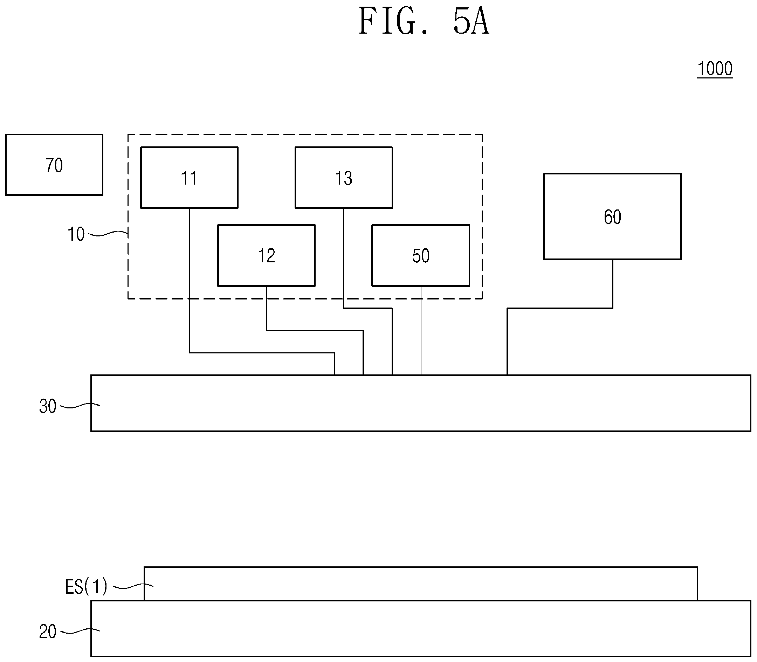

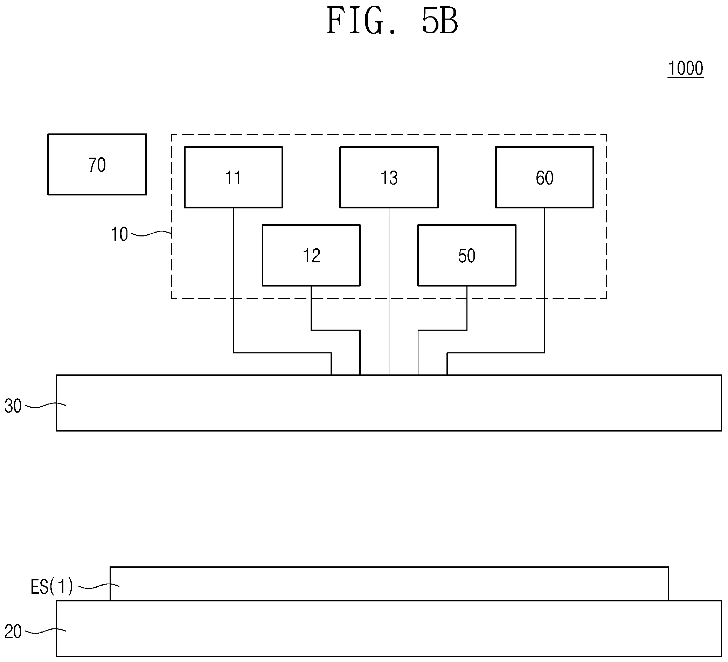

The removal of the electrode capping layer 3c (in S10), the formation of the second gate electrode 4 (in S20), and the nitridation of the upper portion of the second gate electrode 4 (in S30) may be performed in an in-situ manner. In the present specification, the term "in-situ" may be used to represent a process method of successively performing a plurality of processes in a single process chamber. In the case where the processes are performed in the in-situ manner, an internal space of the process chamber may be maintained to be in a vacuum state, during the processes. In some example embodiments, all of the removal, formation, and nitridation processes (in S10, S20, and S30) may be performed in the in-situ manner (e.g., in the same fabrication apparatus). In detail, the base substrate 2 may be loaded in the fabrication apparatus, before the removal process (in S10). Next, the removal, formation, and nitridation processes (in S10, S20, and S30) may be sequentially performed in the fabrication apparatus, and then, the base substrate 2 may be unloaded from the fabrication apparatus. In some example embodiments, the processes may be performed in the in-situ manner, in a fabrication apparatus 1000, which will be described with reference to FIGS. 5A and 5B.

Since the processes S10, S20, and S30 are performed in the in-situ manner, it may be possible to reduce a process time required to fabricate the electrode structure ES of FIG. 4. In particular, it may be possible to reduce an idle time between the removal process S10 and the formation process S20. Accordingly, it may be possible to effectively prevent or reduce a portion of the first gate electrode 3 from being again oxidized (e.g., from forming an electrode capping layer 3c). As a result, it may be possible to improve productivity of the electrode structure ES and to reduce a failure in the fabrication process.

Referring to FIGS. 1 and 4, the electrode structure ES may be formed by forming a third gate electrode 6 on the second gate electrode 4. The interface pattern 5 may be interposed between the second gate electrode 4 and the third gate electrode 6. The third gate electrode 6 may be formed in the trench region 9 and at a level lower than the top surface of the base substrate 2.

As an example, the formation of the third gate electrode 6 may include forming a third gate layer (not shown) to fill the trench region 9 and cover the top surface of the base substrate 2 and removing an upper portion of the third gate layer to form third gate electrodes 6 spaced apart from each other.

The third gate electrode 6 may be formed of or include a material different from the first and second gate electrodes 3 and 4. For example, the third gate electrode 6 may be formed of or include a material whose work function is greater than that of the second gate electrode 4. Due to the difference in the work function between the second and third gate electrodes 4 and 6, electrical characteristics of the electrode structure ES may be improved. As an example, the second gate electrode 4 may be formed of a material having a work function of 4.2eV or less, and the third gate electrode 6 may be formed of a material having a work function of 4.4eV or greater. In some example embodiments, the third gate electrode 6 may be formed of or include polysilicon that is doped with impurities (e.g., phosphorus and boron).

Since the second gate electrode 4 and the third gate electrode 6 are spaced apart from each other by the interface pattern 5, it may be possible to prevent or reduce the second gate electrode 4 from being mixed with the third gate electrode 6. As an example, in the case where the interface pattern 5 is not formed or the third gate electrode 6 is formed to be in contact with the second gate electrode 4, a mixing issue (e.g., formation of metal silicide) may occur between them. The mixing issue between the second gate electrode 4 and the third gate electrode 6 may be suppressed by the interface pattern 5, the electrical characteristics of the electrode structure may be improved.

FIGS. 5A and 5B are conceptual diagrams illustrating a fabrication apparatus, which is used to fabricate an electrode structure according to some example embodiments of the inventive concepts.

Referring to FIGS. 5A and 5B, the fabrication apparatus 1000 may be provided. As an example, the fabrication apparatus 1000 may be an apparatus that can be used to form the electrode structure ES of a semiconductor device 1. Some steps of the fabrication method described with reference to FIGS. 1 to 4 may be performed in the fabrication apparatus 1000. As an example, some steps of the fabrication method described with reference to FIGS. 1 to 4 may be performed in the in-situ manner, in the fabrication apparatus 1000.

The fabrication apparatus 1000 may include a plate 20. The plate 20 may include a chucking part, on which the semiconductor device 1 (e.g., the electrode structure ES of the semiconductor device 1) can be loaded. When the fabrication apparatus 1000 is operated, the semiconductor device 1 may be loaded on and fastened (e.g. clamped) to the chucking part.

In some example embodiments, the plate 20 may include a heater (not shown). As an example, the plate 20 may be a heater including a chucking part, but the inventive concepts are not limited to this example. The heater may be configured to perform a heating operation when the fabrication apparatus 1000 is operated. The plate 20 may be heated to a predetermined (or, alternatively, desired or selected) temperature that is higher than the room temperature (e.g., 25°C), by the heater. For example, the plate 20 may be heated to a temperature of 650°C or higher by the heater.

The fabrication apparatus 1000 may include a shower head 30. The shower head 30 may be placed to face the plate 20. The shower head 30 may include a supplying part. The supplying part of the shower head 30 may be placed to face the plate 20. When the fabrication apparatus 1000 is operated, the shower head 30 may supply a material, which is required for a fabrication process, toward the plate 20 (e.g., toward the semiconductor device 1) through the supplying part. In some example embodiments, the shower head 30 may be configured to uniformly supply the material onto a top surface of the semiconductor device 1 through the supplying part. The shower head 30 may include one or more nozzles/outlets for supplying material (e.g. a plurality of nozzles/outlets). The shower head 30 may be configured to supply a variety of materials based on which material(s) are supplied to the shower head 30.

The fabrication apparatus 1000 may include a gas box 10. The gas box 10 may include a plurality of boxes. For example, a first box 50, a precursor box 11, a purge box 12, and a reactant box 13 may be provided in the gas box 10. The first box 50, the precursor box 11, the purge box 12, and the reactant box 13 may be connected to the shower head 30 and may deliver respective materials therein to the shower head 30. As an example, each of the first box 50, the precursor box 11, the purge box 12, and the reactant box 13 may be connected to the shower head 30 through respective conduit lines and may deliver the respective materials therein to the shower head 30 through the conduit lines. Upon receipt of the respective materials, the shower head 30 may supply the respective materials onto the top surface of the semiconductor device 1.

When the fabrication apparatus 1000 is operated, the first box 50 may contain a first material. For example, the first material may include the etchant described with reference to FIG. 2, and the first box 50 may be an etchant box, which is configured to store the etchant. As an example, the first material may include chlorine (Cl) atoms (e.g. may contain one or more compounds containing one or more chlorine atoms) and may be used to remove or etch the electrode capping layer 3c described with reference to FIG. 2. The first box 50 may provide the first material to the shower head 30, in the removal process (in S10) described with reference to FIG. 2. The shower head 30 may be configured to supply (e.g., eject) the first material, which is provided from the first box 50, toward the plate 20. For example, during the removal process (in S10) described with reference to FIGS. 1 and 2, the first box 50 may deliver the first material to the shower head 30. The first material, which is provided from the first box 50, may be supplied toward the plate 20 through the shower head 30 and may be used to etch the electrode capping layer 3c of FIG. 2. As a result, the top surface of the first gate electrode 3 of FIG. 2 may be exposed to the outside.

When the fabrication apparatus 1000 is operated, the precursor box 11 may contain a precursor material. For example, the precursor material in the precursor box 11 may include the precursor described with reference to FIG. 3. The precursor box 11 may provide the precursor to the shower head 30. For example, during the formation process (in S20) of the second gate electrode 4 described with reference to FIGS. 1 and 3, the precursor box 11 may deliver the precursor to the shower head 30. The shower head 30 may be configured to supply the precursor, which is delivered from the precursor box 11, toward the plate 20. As a result of the processes, the precursor may be deposited on the top surface of the first gate electrode 3 of FIG. 3.

When the fabrication apparatus 1000 is operated, the purge box 12 may contain a purge gas. For example, the purge gas in the purge box 12 may include the inert gas described with reference to FIG. 3. The purge box 12 may provide the purge gas to the shower head 30. For example, during the formation process (in S20) of the second gate electrode 4 described with reference to FIGS. 1 and 3, the purge box 12 may deliver the purge gas to the shower head 30. The shower head 30 may be configured to supply the precursor, which is delivered from the purge box 12, toward the plate 20. The purge process of FIG. 3 may be performed through this process.

When the fabrication apparatus 1000 is operated, the reactant box 13 may contain a reactant. For example, the reactant in the reactant box 13 may include the reactant described with reference to FIG. 3. The reactant box 13 may provide the reactant to the shower head 30. For example, during the formation process (in S20) of the second gate electrode 4 described with reference to FIGS. 1 and 3, the reactant box 13 may deliver the reactant to the shower head 30. The shower head 30 may be configured to supply the reactant, which is delivered from the reactant box 13, toward the plate 20. The created material and the residual material described with reference to FIG. 3 may be formed by a chemical reaction between the reactant and the precursor.

The fabrication apparatus 1000 may include a controller 70. The controller 70 may be a mass flow controller (MFC). The controller 70 may be configured to control an operation of at least one of the boxes in the gas box 10. As an example, the controller 70 may be configured to control an operation of the first box 50, and in this case, the flow rate of the first material may be controlled by the controller 70. As another example, the controller 70 may also control operations of the precursor box 11, the purge box 12, and/or the reactant box 13 (e.g. to control respective flow rate(s)). The controller 70 may be configured to control the fabrication apparatus 1000 to perform the method of FIG. 1.

The fabrication apparatus 1000 may include a second box 60. The second box 60 may contain a second material, which is different from the first material. For example, the second box 60 may contain the second material, which is used for the nitridation process (in S30) described with reference to FIG. 3. The second material may include nitrogen (N). The shower head 30 may be configured to supply the second material, which is provided from the second box 60, toward the plate 20. For example, when the nitridation process (in S30) is performed, the second box 60 may deliver the second material to the shower head 30. The second material, which is delivered from the second box 60, may be supplied toward the plate 20 through the shower head 30, and in this case, the second gate electrode 4 of FIG. 3 may be nitridated. As a result, an interface pattern IF may be formed on the second gate electrode 4.

As an example, the second material may include plasma. The second box 60 may be a plasma box including a plasma generator. The plasma may be generated in the plasma box by the plasma generator. The plasma may include nitrogen plasma. In some example embodiments, the plasma box may include a remote plasma source (RPS). The remote plasma source may be configured to generate the plasma. Accordingly, the plasma, which is separately generated in the plasma box, may be supplied toward the plate 20. As a result, the nitridation process (in S30) may be performed.

As another example, the second material may include an interface forming gas containing nitrogen atoms (e.g. containing one or more compounds containing one or more nitrogen atoms). The plate 20 may be heated by the heater while the second material is supplied to the plate 20. Since the plate 20 is heated, the nitridation process (in S30) using the second material may be expedited. Here, the controller 70 may control the operation of the second box 60; that is, the flow of the second material may be controlled by the controller 70.

As an example, as shown in FIG. 5A, the second box 60 may be placed outside the gas box 10. As another example, as shown in FIG. 5B, the second box 60 may be placed in the gas box 10.

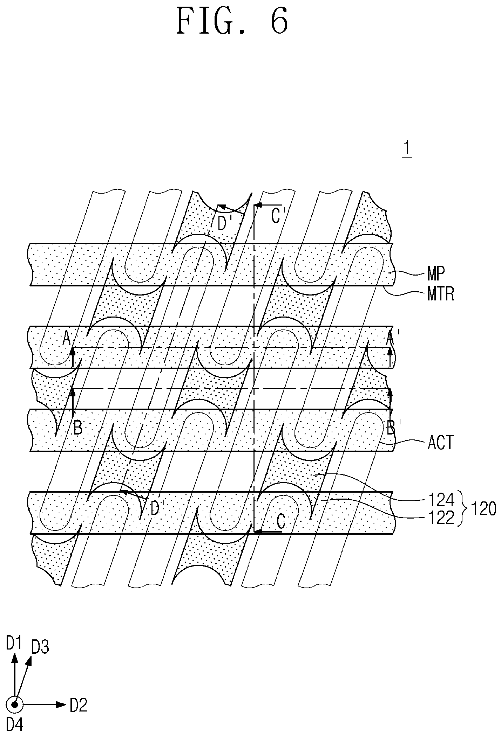

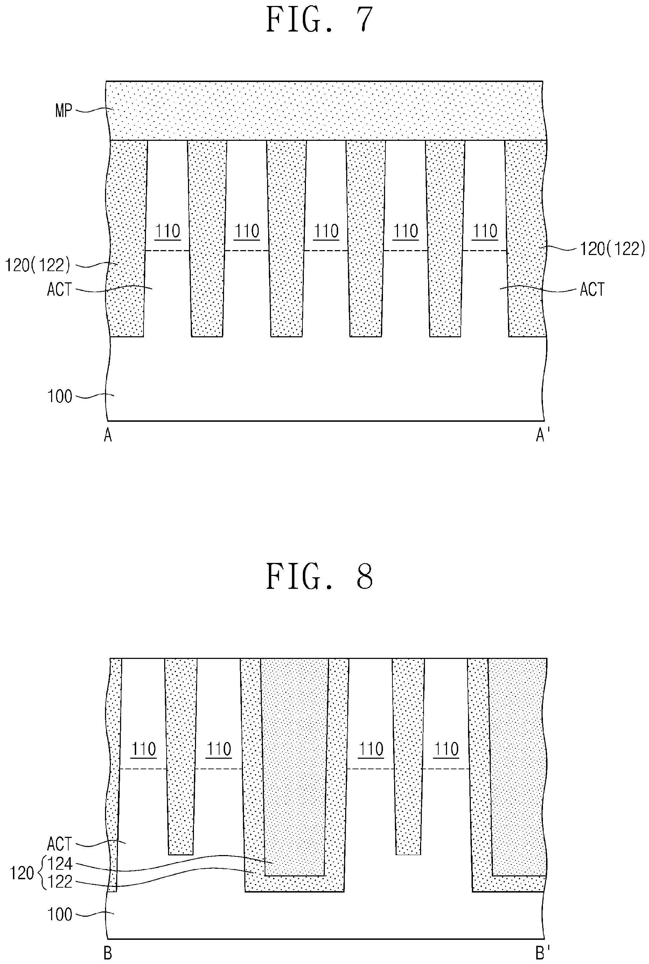

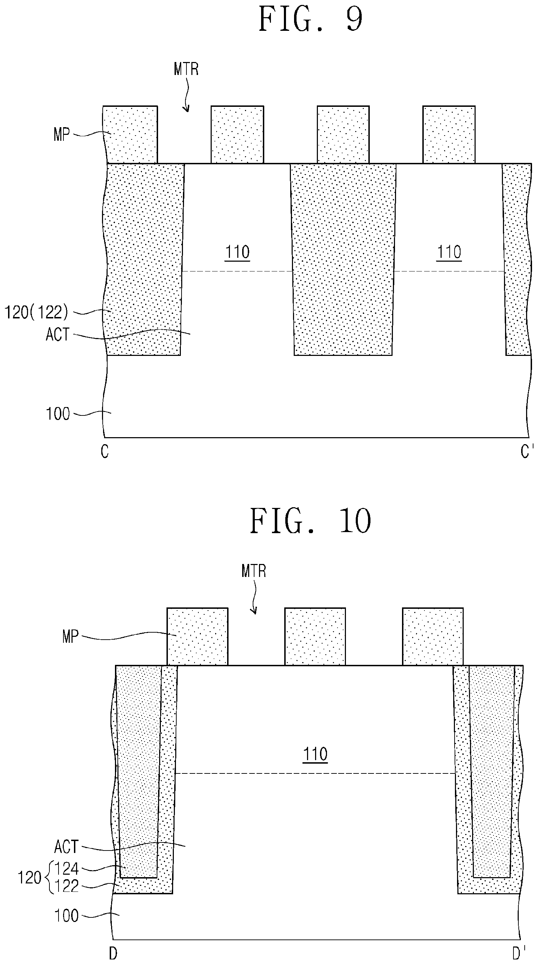

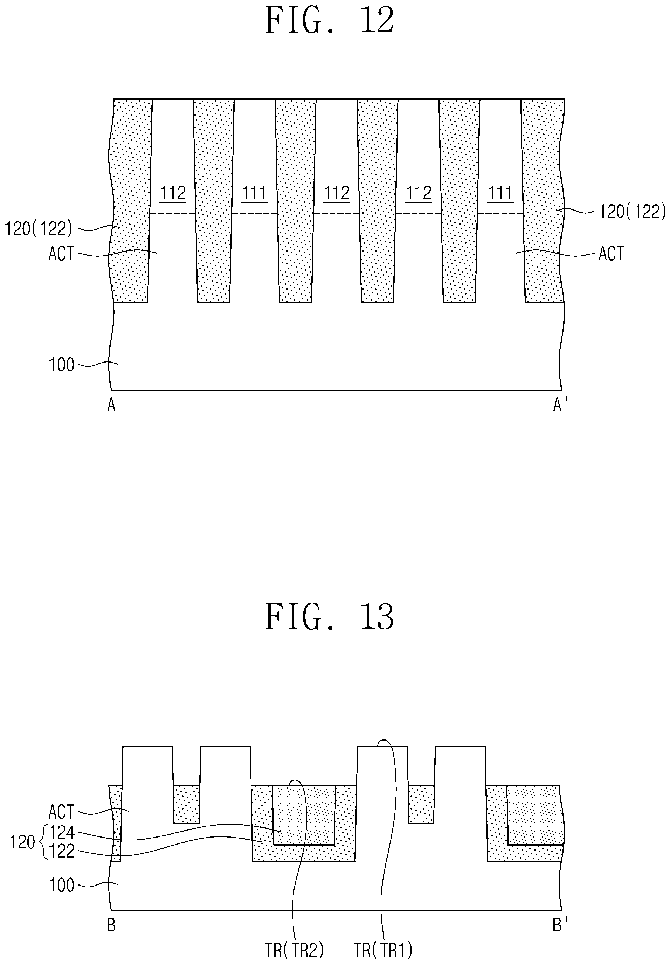

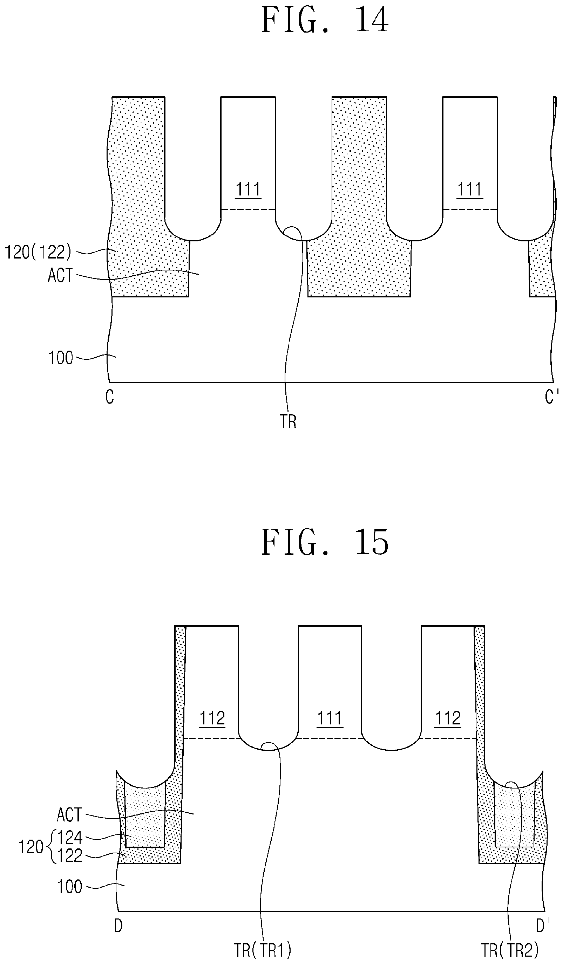

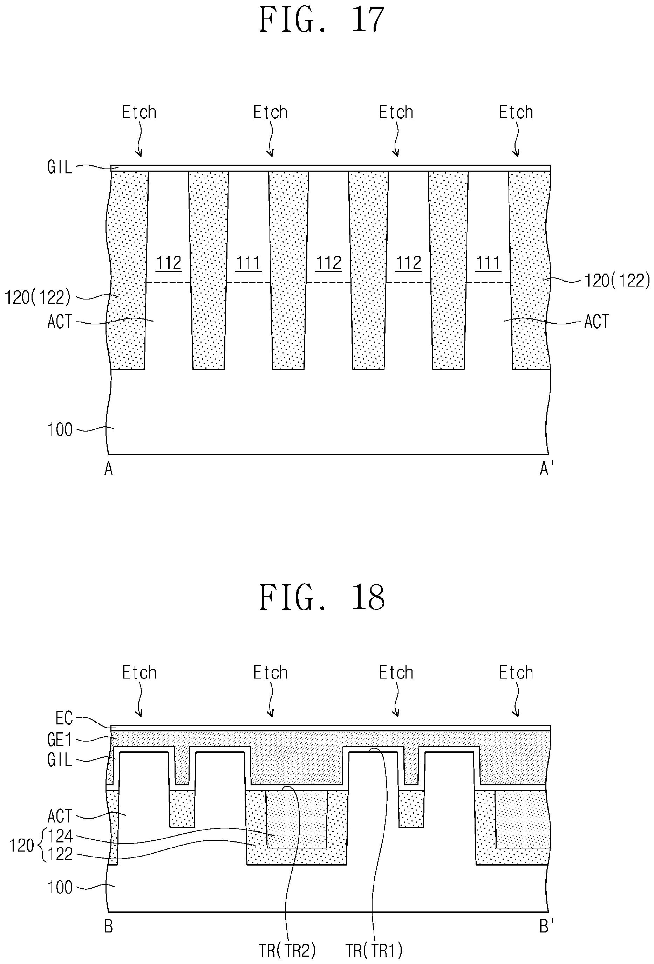

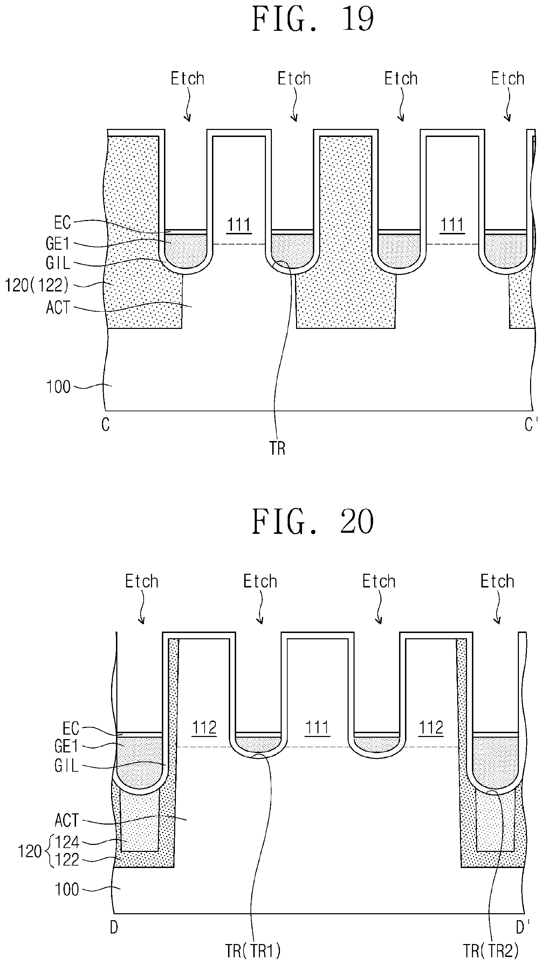

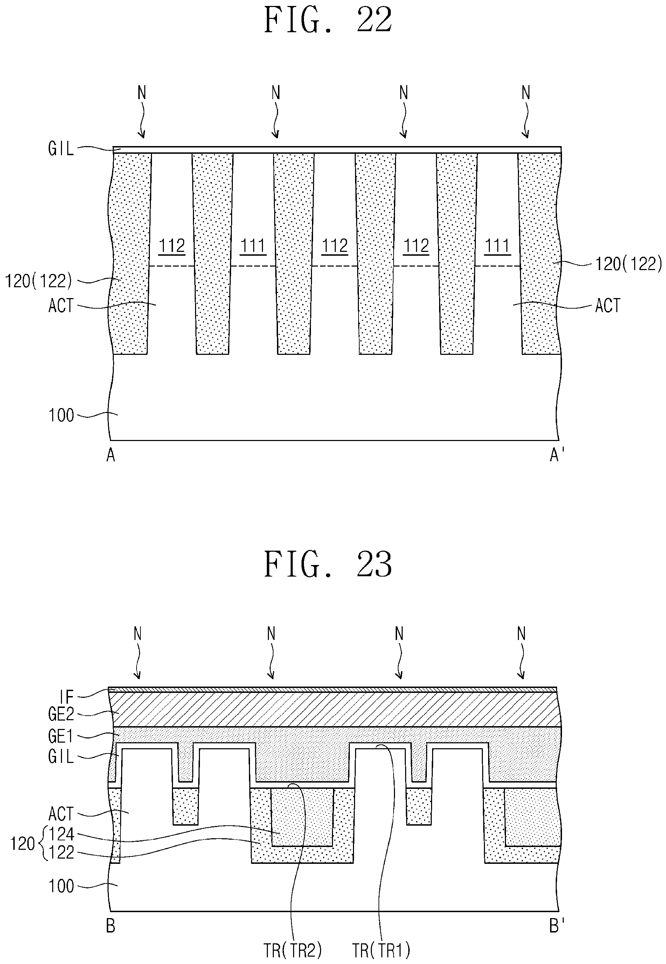

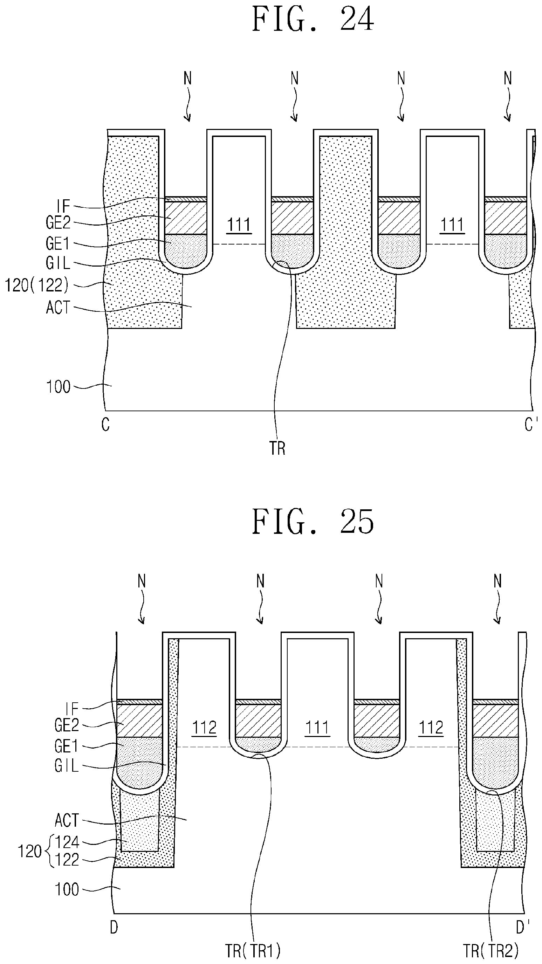

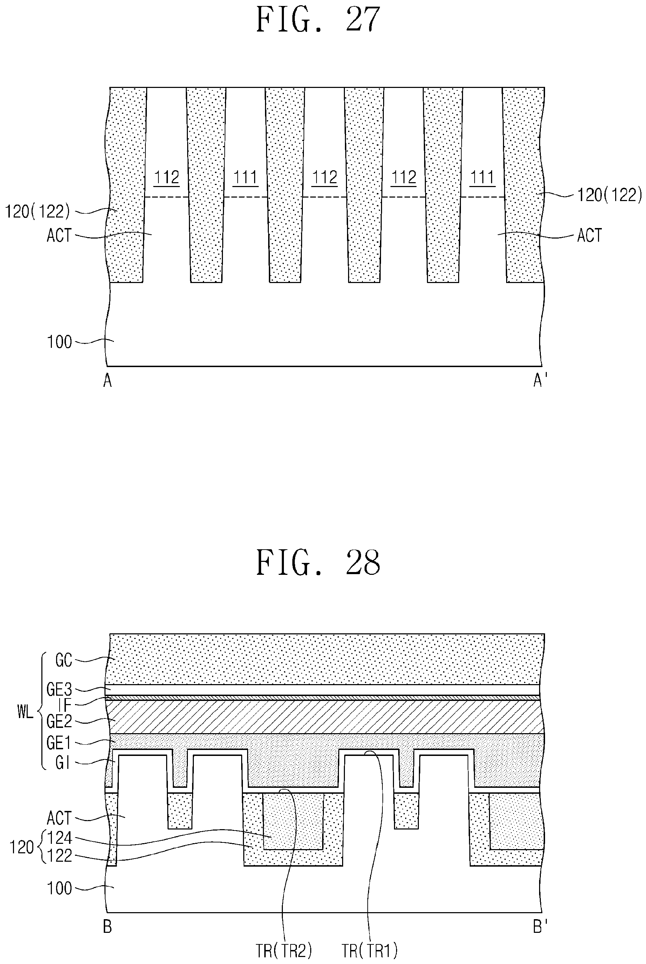

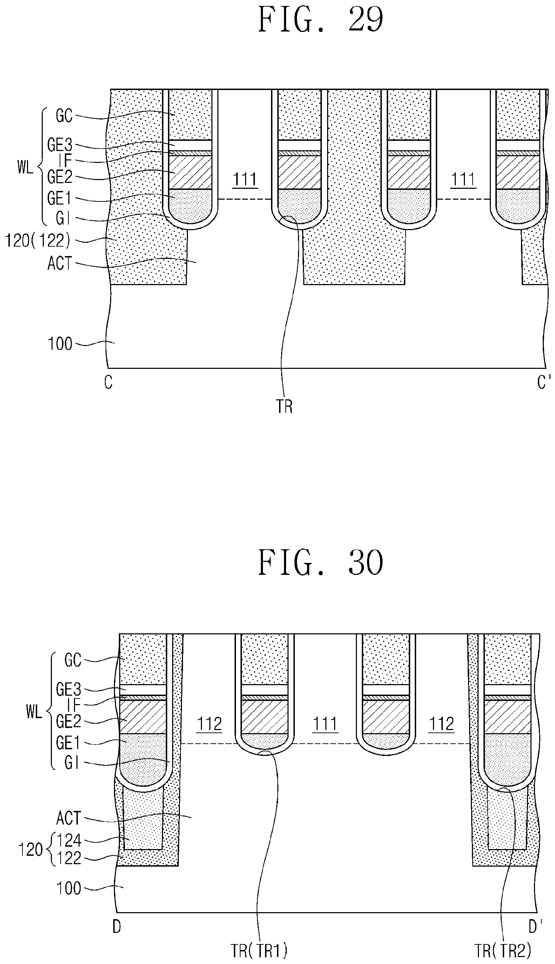

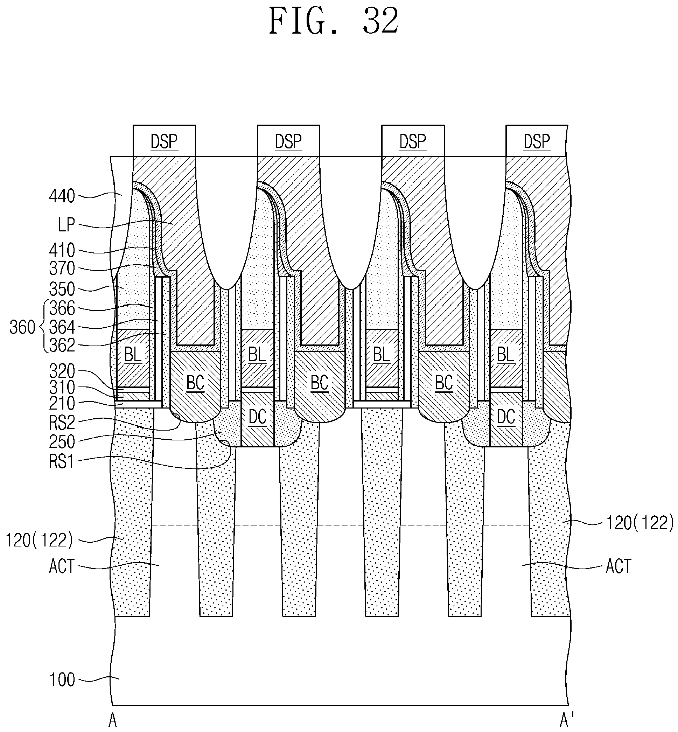

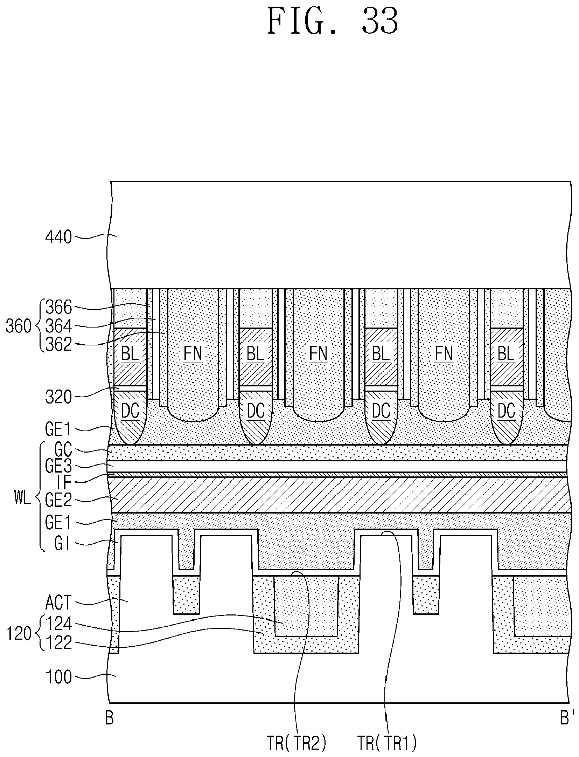

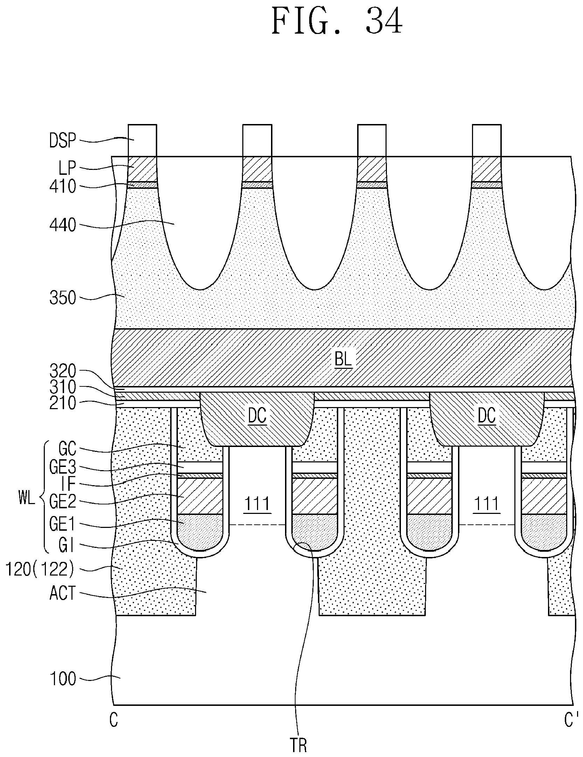

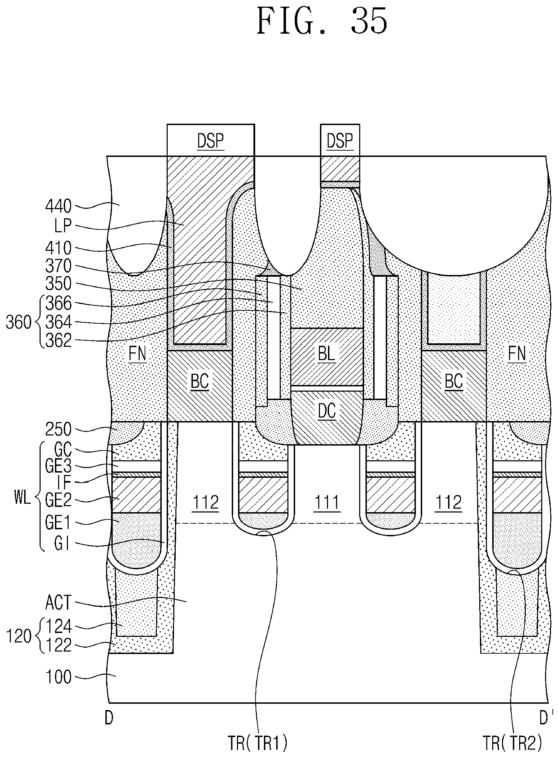

FIGS. 6 to 34 are diagrams illustrating a method of fabricating a semiconductor device including an electrode structure according to some example embodiments of the inventive concepts. In detail, FIGS. 6, 11, 16, 21, 26, and 31 are plan views illustrating a method of fabricating a semiconductor device including an electrode structure, according to some example embodiments of the inventive concepts. FIGS. 7, 12, 17, 22, 27, and 32 are sectional views taken along lines A-A' of FIGS. 6, 11, 16, 21, 26, and 31, respectively. FIGS. 8, 13, 18, 23, 28, and 33 are sectional views taken along lines B-B' of FIGS. 6, 11, 16, 21, 26, and 31, respectively. FIGS. 9, 14, 19, 24, 29, and 34 are sectional views taken along lines C-C' of FIGS. 6, 11, 16, 21, 26, and 31, respectively. FIGS. 10, 15, 20, 25, 30, and 35 are sectional views taken along lines D-D' of FIGS. 6, 11, 16, 21, 26, and 31, respectively. For concise description, a previously described element may be identified by the same reference number without repeating an overlapping description thereof.

Referring to FIGS. 6 to 10, a substrate 100 may be prepared. The substrate 100 may be one of semiconductor substrates, such as a silicon wafer, a germanium wafer, and a silicon-germanium wafer.

A device isolation pattern 120 may be formed in an upper portion of the substrate 100. The formation of the device isolation pattern 120 may include performing a patterning process to etch a portion of the upper portion of the substrate 100 and filling the etched portion with an insulating material.

The remaining (e.g., unetched) regions of the upper portion of the substrate 100, which are enclosed by the device isolation pattern 120, may be defined as active patterns ACT. Hereinafter, for convenience in description, the other region (e.g., a lower portion) of the substrate 100, except for the active patterns ACT, will be referred to as the substrate 100.

The active patterns ACT may be spaced apart from each other in first and second directions D1 and D2, which are parallel to a bottom surface of the substrate 100 and are not parallel (e.g., orthogonal) to each other. Each of the active patterns ACT may be a bar-shaped pattern, which is extended in a third direction D3 that is not parallel to (e.g. intersects) the first and second directions D1 and D2, and may protrude from the substrate 100 in a fourth direction D4 that is perpendicular to the first to third directions D1, D2, and D3. Widths of the active pattern ACT, which are measured in the first to third directions D1, D2, and D3, may decrease as a distance from the substrate 100 increases. The base substrate 2 of FIG. 2 may include the substrate 100, the active patterns ACT, and the device isolation pattern 120.

Impurity regions 110 may be formed in the active patterns ACT. The formation of the impurity regions 110 may include injecting impurities into the active patterns ACT through an ion implantation process.

The device isolation pattern 120 may have a single-layered structure or a multi-layered structure including two or more materials. As an example, the device isolation pattern 120 may include a first isolation pattern 122, which is provided to enclose each of the active patterns ACT, and a second isolation pattern 124, which is provided between the active patterns ACT separated from each other in the third direction D3, and the first and second isolation patterns 122 and 124 may be formed of or include the same material or different materials. The device isolation pattern 120 may be formed of or include at least one of insulating materials. As an example, the device isolation pattern 120 may be formed of or include at least one of silicon oxide, silicon nitride, or combinations thereof. In some example embodiments, the first isolation pattern 122 and the second isolation pattern 124 may be formed of or include silicon oxide and silicon nitride, respectively, but the inventive concepts are not limited to this example.

A mask pattern MP may be formed on the active patterns ACT and the device isolation pattern 120. The mask pattern MP may include line-shaped patterns, which are extended in the second direction D2 and are spaced apart from each other in the first direction D1. In some example embodiments, the mask pattern MP may be formed to cross the active patterns ACT and the device isolation pattern 120 in the second direction D2. Mask trenches MTR may be formed between the line-shaped patterns of the mask pattern MP. The mask trenches MTR may be extended in the second direction D2 and may be spaced apart from each other in the first direction D1.

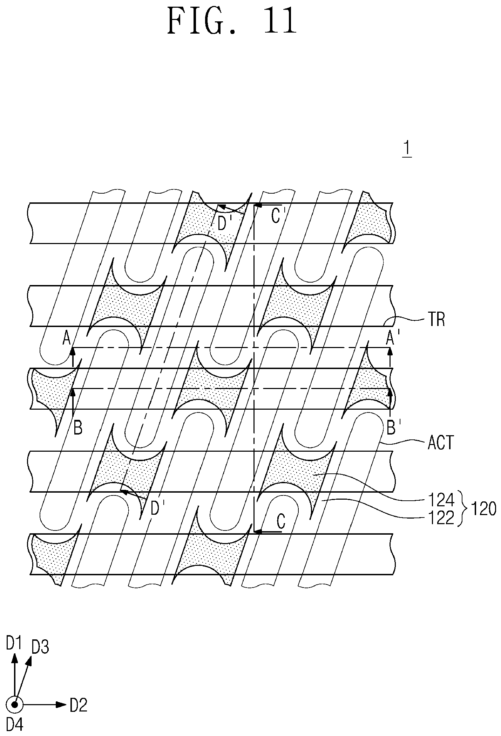

Referring to FIGS. 11 to 15, upper portions of the active patterns ACT and an upper portion of the device isolation pattern 120 may be etched using the mask pattern MP as an etch mask. Accordingly, trench regions TR may be formed in regions that are vertically overlapped with the mask trenches MTR of the mask pattern MP. The trench regions TR may be extended in the second direction D2 and may be spaced apart from each other in the first direction D1. In some example embodiments, a pair of trench regions TR, which are adjacent to each other in the first direction D1, may be formed to cross each of the active patterns ACT in the second direction D2.

A bottom surface of each of the trench regions TR may have an uneven structure. As an example, the trench region TR may include a first trench region TR1 and a second trench region TR2, and in this case, a bottom surface of the first trench region TR1 may be formed at a level higher than a bottom surface of the second trench region TR2. Here, the term "level" may be defined as a height measured from the bottom surface of the substrate 100. The first trench region TR1 may be formed in the active pattern ACT, and the second trench region TR2 may be formed in the device isolation pattern 120. The active pattern ACT and the device isolation pattern 120 may have different etch rates from each other in the etching process, and thus, the bottom surfaces of the first and second trench regions TR1 and TR2 may be formed at different levels.

The impurity regions 110 may include first impurity regions 111 and second impurity regions 112, which are divided by the trench regions TR. The second impurity regions 112 may be formed in opposite edge regions of each of the active patterns ACT. Each of the first impurity regions 111 may be formed between the second impurity regions 112 in each of the active patterns ACT.

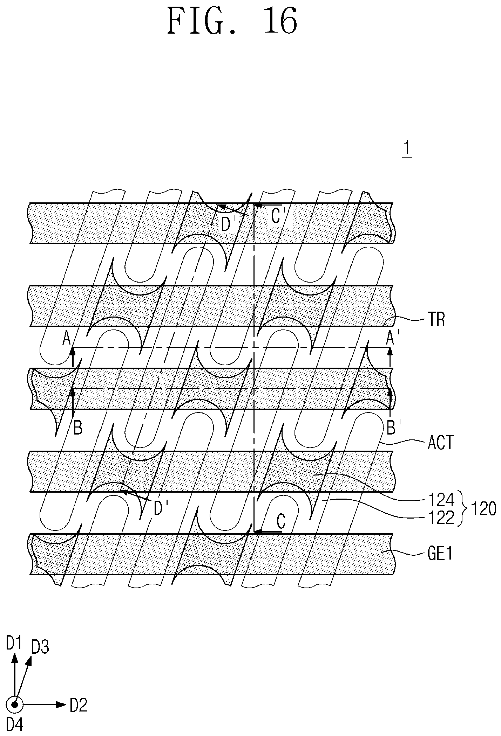

Referring to FIGS. 16 to 20, the gate insulating layer GIL may be conformally formed on the entire top surface of the substrate 100. For example, the gate insulating layer GIL may be formed to conformally cover inner surfaces of the trench regions TR and may be extended to cover top surfaces of the active patterns ACT and a top surface of the device isolation pattern 120. The gate insulating layer GIL may have a bottom surface that is extended along the trench region TR, and thus, the gate insulating layer GIL may have an uneven structure. The gate insulating layer GIL may be formed by performing a physical vapor deposition (PVD) process, a chemical vapor deposition (CVD) process, or an atomic layer deposition (ALD) process. The gate insulating layer GIL may be formed of or include at least one of silicon oxide, high-k dielectric materials, or combinations thereof.

Next, a first gate electrode GE1 may be formed in the trench region TR. A plurality of first gate electrodes GE1 may be formed in the trench regions TR, respectively. The formation of the first gate electrode GE1 may include forming a first gate layer (not shown) to fill the trench regions TR and to cover the gate insulating layer GIL and etching an upper portion of the first gate layer to form a plurality of first gate electrodes GE1 separated from each other. The formation of the first gate layer may include performing a physical vapor deposition (PVD) process, a chemical vapor deposition (CVD) process, or an atomic layer deposition (ALD) process. The etching of the upper portion of the first gate layer may include performing an etch-back process on the first gate layer. Accordingly, the first gate electrode GE1 may fill a lower portion of the trench region TR. Since the upper portion of the first gate layer is etched, an upper portion of the gate insulating layer GIL may be exposed to the outside.

The first gate electrodes GE1 may be extended along the trench regions TR and in the second direction D2 and may be spaced apart from each other in the first direction D1. A bottom surface of the first gate electrode GE1 may have an uneven structure, which corresponds to the bottom surface of the trench region TR. Alternatively, the first gate electrode GE1 may be extended to have a flat top surface. The first gate electrode GE1 may be formed of or include at least one metallic material (e.g., Ti, Mo, W, Cu, Al, Ta, Ru, and Ir), a nitride material of the metallic element, or combinations thereof. The first gate electrode GE1 may be formed of or include, for example, TiN.

In some example embodiments, the electrode capping layer EC may be formed on the first gate electrode GE1. The electrode capping layer EC may be provided to have substantially the same features as the electrode capping layer 3c described with reference to FIGS. 1 and 2.

Next, a removal process may be performed in the trench region TR. The electrode capping layer 3c may be removed through the removal process, and thus, the top surface of the first gate electrode GE1 may be exposed to the outside. The removal process may include an etching process (e.g., a dry etching process or a wet etching process). The etching process may be performed in the same manner as that in some example embodiments described with reference to FIGS. 1 and 2 and may be performed using the fabrication apparatus described with reference to FIGS. 5A and 5B.

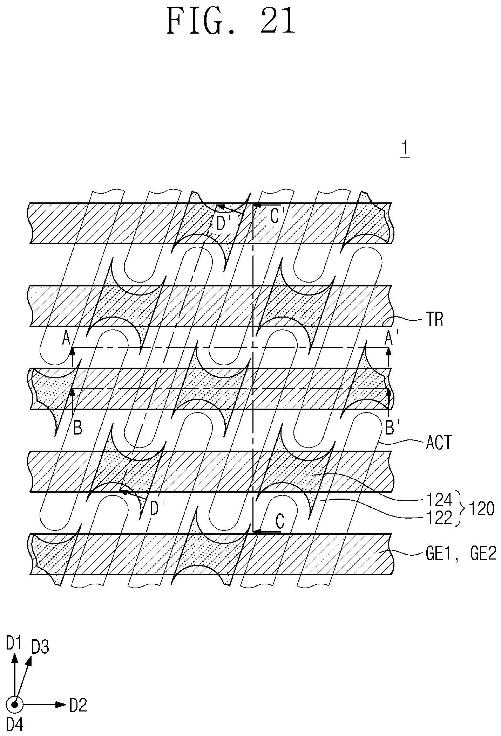

Referring to FIGS. 21 to 25, a second gate electrode GE2 may be formed on the first gate electrode GE1. The formation process of the second gate electrode GE2 may be performed in the same manner as the formation process of the second gate electrode 4 described with reference to FIGS. 1 and 3 and may be performed using the fabrication apparatus described with reference to FIGS. 5A and 5B. The second gate electrode GE2 may have substantially the same features as the second gate electrode 4 described with reference to FIGS. 1 and 3. Furthermore, a precursor, a purge gas, and a reactant, which are used in the formation process of the second gate electrode GE2, may be provided to have substantially the same features as those in some example embodiments of FIGS. 1 and 3.

According to some example embodiments of the inventive concepts, as described above, it may be possible to easily form the second gate electrode GE2 on the first gate electrode GE1 and to reduce a failure in the process of fabricating the semiconductor device 1. In addition, since the second gate electrode GE2 is easily formed, the electrical and reliability characteristics of the semiconductor device 1 may be improved.

After the formation of the second gate electrode GE2, an upper portion of a second gate electrode GE4 may be nitridated. Accordingly, the interface pattern IF may be formed on the second gate electrode GE2. The nitridation process and the interface pattern IF may be provided to have substantially the same features as those in FIGS. 1 and 3.

As previously described with reference to FIGS. 1 to 3, the removal process of the electrode capping layer 3c, the formation process of the second gate electrode GE2, and the nitridation process may be performed in the in-situ manner. As an example, the processes may be performed in the in-situ manner, the fabrication apparatus 1000 of FIGS. 5A and 5B.

Since the processes are performed in the in-situ manner, it may be possible to reduce a process time required to fabricate the semiconductor device 1 and to reduce a failure in the fabrication process. Accordingly, it may be possible to improve productivity in a process of fabricating the semiconductor device 1 and to improve electrical and reliability characteristics of the semiconductor device 1.

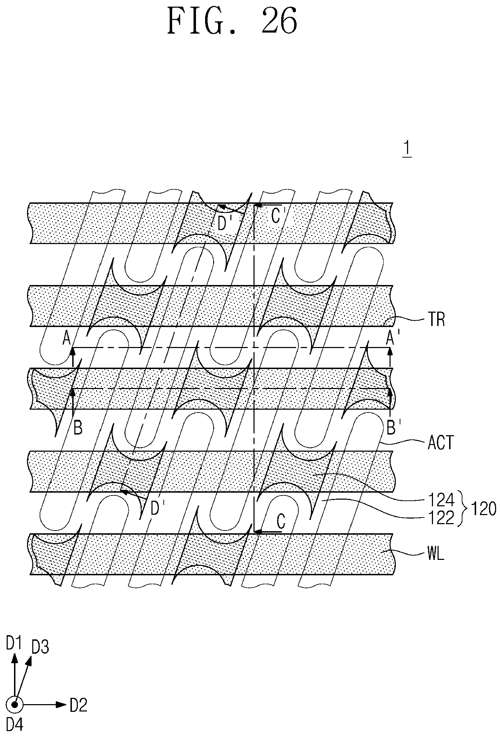

Referring to FIGS. 26 to 30, a third gate electrode GE3 may be formed on the second gate electrode GE2. The third gate electrode GE3 and the process of forming the third gate electrode GE3 may be substantially the same as those in some example embodiments described with reference to FIGS. 1 and 4.

The interface pattern IF may be interposed between the second gate electrode GE2 and the third gate electrode GE3, and in this case, it may be possible to prevent or reduce the second gate electrode GE2 from being mixed with the third gate electrode GE3. As a result, the electrical and reliability characteristics of the semiconductor device 1 may be improved.

A gate capping pattern GC may be formed on the third gate electrode GE3. The gate capping pattern GC may be provided to fill a remaining portion of the trench region TR. The formation of the gate capping pattern GC may include forming a gate capping layer (not shown) to fill the remaining portion of the trench region TR and to cover the top surfaces of the active patterns ACT and the device isolation pattern 120 and removing an upper portion of the gate capping layer to form the gate capping patterns GC, which are separated from each other.

A gate insulating pattern GI may be formed by removing an upper portion of the gate insulating layer GIL. In detail, a portion of the gate insulating layer GIL, which cover the top surfaces of the active patterns ACT and the top surface of the device isolation pattern 120, may be removed, and remaining (e.g., unremoved) portions of the gate insulating layer GIL may be used as the gate insulating patterns GI. The gate insulating pattern GI may be formed to conformally cover the inner surface of the trench region TR. The gate insulating pattern GI may be interposed between the first gate electrode GE1 and the active pattern ACT, between the second gate electrode GE2 and the active pattern ACT, and between the third gate electrode GE3 and the active pattern ACT. The first to third gate electrodes GE1, GE2, and GE3, the gate insulating pattern GI, the interface pattern IF, and the gate capping pattern GC may constitute the word line WL.

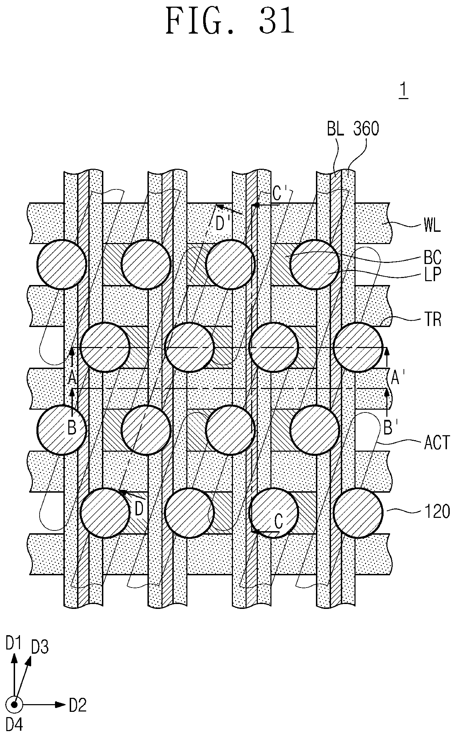

Referring to FIGS. 31 to 35, a buffer layer (not shown) and a poly-silicon layer (not shown) may be formed to cover the active patterns ACT and the device isolation pattern 120, and a first recess region RS1 may be formed in an upper portion of each of the active patterns ACT and the device isolation pattern 120. A buffer pattern 210 and a polysilicon pattern 310 may be formed by partially removing the buffer layer and the poly-silicon layer. As an example, the buffer pattern 210 may be formed of or include at least one of silicon oxide, silicon nitride, silicon oxynitride, or combinations thereof. As an example, the polysilicon pattern 310 may be formed of or include polysilicon.

A bit line contact DC, a bit line BL, and a bit line capping pattern 350 may be formed on the first recess region RS1. The formation of the bit line contact DC, the bit line BL, and the bit line capping pattern 350 may include forming a bit line contact layer (not shown) to fill the first recess region RS1, sequentially forming a bit line layer (not shown) and a bit line capping layer (not shown) on the bit line contact layer, and etching the bit line contact layer, the bit line layer, and the bit line capping layer to form the bit line contact DC, the bit line BL, and the bit line capping pattern 350. During this process, an inner portion of the first recess region RS1 may be partially exposed to the outside. Next, a gapfill pattern 250 may be formed to fill a remaining portion of the first recess region RS1. The bit line contact DC may be formed of or include, for example, polysilicon. The bit line BL may be formed of or include at least one of, for example, tungsten, rubidium, molybdenum, titanium, or combinations thereof. The bit line capping pattern 350 may be formed of or include, for example, silicon nitride. During the formation of the bit line BL, a first ohmic pattern 320 may be further formed between the bit line BL and the bit line contact DC and between the bit line BL and the polysilicon pattern 310. The first ohmic pattern 320 may be formed of or include at least one of metal silicide materials.

A bit line spacer 360 may be formed to cover a side surface of the bit line BL and a side surface of the bit line capping pattern 350. The formation of the bit line spacer 360 may include sequentially forming a first bit line spacer 362, a second bit line spacer 364, and a third bit line spacer 366 to conformally cover the bit line BL and the bit line capping pattern 350. As an example, each of the first to third bit line spacers 362, 364, and 366 may be formed of or include at least one of silicon nitride, silicon oxide, silicon oxynitride, or combinations thereof. As another example, the second bit line spacer 364 may include an air gap, which is formed to separate the first and third bit line spacers 362 and 366 from each other.

Storage node contacts BC and fence patterns FN may be formed between adjacent ones of the bit lines BL. The storage node contacts BC and the fence patterns FN may be alternately arranged in the second directions D2. Each of the storage node contacts BC may fill a second recess region RS2 and may be electrically connected to a corresponding one of the second impurity regions 112, in the second recess region RS2. The fence patterns FN may be formed at positions, which are vertically overlapped with the word lines WL. As an example, the storage node contacts BC may be firstly formed, and then, the fence patterns FN may be formed between the storage node contacts BC. As another example, the fence patterns FN may be firstly formed, and then, the storage node contacts BC may be formed between the fence patterns FN. In some example embodiments, the storage node contacts BC may be formed of or include at least one of doped or undoped polysilicon, metallic materials, or combinations thereof. The fence patterns FN may be formed of or include, for example, silicon nitride.

In the process of forming the storage node contacts BC, an upper portion of the bit line spacer 360 may be partially removed. In this case, a spacer capping pattern 370 may be further formed in a region that is formed by the removing of the bit line spacer 360. The spacer capping pattern 370 may be formed of or include, for example, silicon nitride. Next, a barrier pattern 410 may be formed to conformally cover the bit line spacer 360, the spacer capping pattern 370, and the storage node contacts BC. In some example embodiments, the barrier pattern 410 may be formed of or include at least one of conductive metal nitride materials.

Landing pads LP may be formed on the storage node contacts BC. The formation of the landing pads LP may include sequentially forming a landing pad layer (not shown) and mask patterns (not shown) to cover top surfaces of the storage node contacts BC and performing an anisotropic etching process, in which the mask patterns is used as an etch mask, to form a plurality of landing pads LP, which are spaced apart from each other, from the landing pad layer. During the etching process, at least one of the barrier pattern 410, the bit line spacer 360, and the bit line capping pattern 350 may be partially etched and may be exposed to the outside. An upper portion of the landing pad LP may be shifted from the storage node contact BC in the second direction D2. As an example, the landing pad LP may be formed of or include at least one of metallic materials (e.g., tungsten, titanium, and tantalum).

In some example embodiments, the second bit line spacer 364 may be exposed by the process of etching the landing pad layer. An etching process on the second bit line spacer 364 may be further performed through the exposed portion of the second bit line spacer 364, and in this case, the second bit line spacer 364 may include an air gap. However, the inventive concepts are not limited to this example.

Next, a filling pattern 440 may be formed to cover exposed surfaces of the resulting structure and to enclose each of the landing pads LP, and a data storage pattern DSP may be formed on each of the landing pads LP.

In some example embodiments, the data storage pattern DSP may be a capacitor including a bottom electrode, a dielectric layer, and a top electrode. In this case, the semiconductor memory device according to some example embodiments of the inventive concepts may be a dynamic random access memory (DRAM) device. As another example, the data storage pattern DSP may include a magnetic tunnel junction pattern. In this case, the semiconductor memory device may be magnetic random access memory (MRAM) device. In some example embodiments, the data storage pattern DSP may include a phase-change material or a variable resistance material. In this case, the semiconductor memory device may be a phase-change random access memory (PRAM) device or a resistive random access memory (ReRAM) device. However, the inventive concepts are not limited to this example, and the data storage pattern DSP may include various structures and/or materials, which can be used to store data therein.

According to some example embodiments of the inventive concepts, it may be possible to easily form a second gate electrode on a first gate electrode and thereby to improve electrical characteristics in an electrode structure. In addition, an interface pattern may be formed on the second gate electrode, and in this case, it may be possible to prevent or reduce the second gate electrode from being mixed with a third gate electrode. As a result, it may be possible to improve electrical characteristics of the electrode structure and to reduce a failure in a fabrication process.

Furthermore, a plurality of processes may be performed in an in-situ manner, an apparatus for fabricating the electrode structure. Accordingly, it may be possible to improve productivity in a process of forming the electrode structure.

While example embodiments of the inventive concepts have been particularly shown and described, it will be understood by one of ordinary skill in the art that variations in form and detail may be made therein without departing from the scope of the attached claims.

## Claims

1. An apparatus for fabricating an electrode structure, comprising:
a plate;
a shower head configured to provide plasma to the plate;
a plasma box configured to provide the plasma to the shower head;
a precursor box configured to provide a precursor to the shower head;
a purge box configured to provide a purge gas to the shower head; and
a reactant box configured to provide a reactant to the shower head.

2. The apparatus of claim 1, wherein the plasma box is configured to generate the plasma therein.

3. The apparatus of claim 1 or claim 2, wherein the plasma comprises nitrogen plasma.

4. The apparatus of any preceding claim, further comprising an etchant box configured to provide an etchant to the shower head,
wherein the shower head is further configured to provide the etchant to the plate.

5. The apparatus of claim 4, wherein the etchant comprises an etchant material capable of etching a metal oxide.

6. The apparatus of claim 4 or claim 5, wherein the etchant includes a chlorine atom.

7. An apparatus for fabricating an electrode structure, comprising:
a plate;
a shower head configured to supply an etchant and an interface forming gas toward the plate;
a first box configured to provide the etchant to the shower head;
a second box configured to provide the interface forming gas to the shower head;
a precursor box configured to provide a precursor to the shower head;
a purge box configured to provide a purge gas to the shower head; and
a reactant box configured to provide a reactant to the shower head,
the plate including a heater, and
the interface forming gas including a nitrogen atom.

8. The apparatus of claim 7, wherein the heater is configured to heat to a temperature of 650°C or higher.

9. The apparatus of claim 7 or claim 8, further comprising a gas box,
wherein the first box and the second box are placed in the gas box.

10. The apparatus of any of claims 7-9, further comprising a controller,
wherein the controller is configured to control operations of the first box and the second box.

11. The apparatus of any of claims 7-10, wherein the etchant comprises an etchant material capable of etching a metal oxide.

12. The apparatus of any of claims 7-11, wherein the etchant includes a chlorine atom.
